# EUROPEAN PATENT APPLICATION

(11) **EP 4 468 175 A1**
(43) Date of publication of application: **27.11.2024**
(21) Application number: 22927919.5
(22) Date of filing: 28.02.2022
(51) Int. Cl.: G06F 18/00

(54) **BATTERY FAULT DETECTION SYSTEM, METHOD AND APPARATUS**

(71) Applicant: Contemporary Amperex Technology (Hong Kong) Limited, Central, Central And Western District (HK)
(72) Inventor: LIU, Hongyang, Ningde, Fujian 352100 (CN); ZHAO, Wei, Ningde, Fujian 352100 (CN)
(74) Representative: Ran, Handong
(86) International application number: PCT/CN2022/078479
(87) International publication number: WO 2023/159638

(57) **Abstract**

Provided in the embodiments of the application are a battery fault detection system, method and apparatus. The system comprises: a first data warehouse used for storing historical operation data of a battery; a fault detection module used for acquiring the corresponding battery historical operation data from the first data warehouse and performing feature extraction so as to obtain corresponding fault detection feature data; a batch computation module used for batch computation on the fault detection feature data by means of a batch computation engine so as to obtain corresponding intermediate parameters; and a stream computation platform which is used for acquiring the intermediate parameters and real-time operation data of the battery and performing fusion computation in real time by means of a stream computation engine, so as to obtain a fault detection result of the corresponding battery.

## Description

### TECHNICAL FIELD

This application relates to the field of battery technologies, and in particular, to a battery fault detection system and method, and a device.

### BACKGROUND

As the main power source for new energy vehicles, batteries may often experience fault problems after long-term operation, which affects the safe operation of new energy vehicles. Therefore, fault detection of the battery is particularly important.

Due to the strong correlation between the faults of power batteries and the time sequence, currently in power battery fault identification, computations usually need to be performed for data over a long time span to ensure the reliability of a warning result. However, the real-time nature of the detection is also crucial for power battery fault detection. Therefore, how to take into account both reliability and real-time nature is an urgent problem to be solved in this field.

### SUMMARY

This application provides a battery fault detection system and method, and a device, to take into account both the accuracy and real-time nature of battery fault detection.

According to a first aspect, an embodiment of this application provides a battery fault detection system, including: a first data warehouse, configured to store battery historical operation data; a fault detection module, configured to acquire corresponding battery historical operation data from the first data warehouse for feature extraction to obtain corresponding fault detection feature data; a batch computing module, configured to perform batch computing on the fault detection feature data through a batch computing engine to obtain corresponding intermediate parameters; and a stream computing platform, configured to acquire the intermediate parameters and battery real-time operation data in real time through a stream computing engine for fusion computations to obtain a fault detection result of a corresponding battery.

According to this embodiment of this application, the first data warehouse can store massive amounts of historical operation data, from which the fault detection module can acquire historical operation data over a sufficient time span for feature extraction, thereby obtaining more accurate and reliable fault detection feature data. Then, the batch computing module performs batch computing on the large amount of fault detection feature data through the batch computing engine to quickly obtain corresponding intermediate parameters, ensuring that subsequently, the stream computing platform can acquire the intermediate parameters in a timely manner in performing real-time fusion computations. The stream computing platform can acquire the intermediate parameters and battery real-time operation data in real time through the stream computing engine for fusion computations to obtain a real-time fault detection result of a corresponding battery. Since the fault detection result is derived through corresponding feature extraction and fusion computations from the historical operation data and real-time operation data of the battery, the accuracy rate is higher, the false alarm rate of battery risk identification is reduced, and the reliability of battery fault detection is improved. Moreover, in this embodiment of this application, the stream computing platform can be used to perform real-time acquisition and computation processing of large-scale streaming data (that is, battery real-time operation data) based on the stream computing engine, and the batch computing module provides fast computation capability for the intermediate parameters before the computation processing, further ensuring real-time execution of the computation processing. Therefore, this embodiment of this application can ensure the real-time nature of fault detection while taking the reliability of the detection result into account, facilitating timely fault response to battery fault risks and providing a guarantee for the safe operation of power batteries.

In some embodiments, the system further includes a second data warehouse. The second data warehouse is configured to store the intermediate parameters and battery real-time operation data in real time for access by the stream computing platform.

According to the embodiments of this application, since the real-time operation data of the battery is continuously updated, to enable the stream computing platform to acquire in real time and process in a timely and effective manner the real-time operation data generated by the battery, the system in the embodiments can store in real time the intermediate parameters computed by the batch computing module and the battery real-time operation data acquired from the terminal through the data warehouse, thereby providing a guarantee for data reading in the streaming fusion computation process of the stream computing platform.

In some embodiments, the stream computing platform includes: a data interface, configured to collect real-time operation data of corresponding batteries from each terminal through Internet of Things protocols; a first transmission unit, configured to transmit the real-time operation data to the second data warehouse to update existing battery real-time operation data stored in the second data warehouse; and a second transmission unit, configured to transmit the real-time operation data to the first data warehouse for storage to update the battery historical operation data.

According to the embodiments of this application, the data platform collects real-time operation data of batteries from each terminal through the data interface based on the Internet of Things protocols, completing big data collection for risk identification for batches of batteries, thereby facilitating large-scale battery risk identification and management. The acquired real-time operation data is transmitted to the second data warehouse through the first transmission unit to continuously update the existing battery real-time operation data, thereby continuously providing a data basis for fusion computations for the stream computing platform in real time, improving the real-time nature and reliability of large-scale battery risk identification and management. Moreover, the real-time operation data is also transmitted to the first data warehouse for storage through the second transmission unit, updating the battery historical operation data, accumulating time sequence data basis required for feature extraction by the fault detection module, thereby facilitating the improvement of the robustness of the fault detection module in performing computations based on massive amounts of data and improving the accuracy of battery fault detection.

In some embodiments, the fault detection module includes: a data acquisition unit, configured to acquire, at a preset sampling time, battery historical operation data for a corresponding sampling period from the first data warehouse and input the data into a feature extraction unit according to a time sequence; and the feature extraction unit, configured to perform multi-dimensional feature extraction on the battery historical operation data through a preset first fault detection model and output corresponding fault detection feature data.

According to the embodiments of this application, the fault detection module includes a data acquisition unit and a feature extraction unit, where the data acquisition unit is configured to acquire, at a preset sampling time, battery historical operation data from the first data warehouse and input the data into the feature extraction unit according to a time sequence, enabling the feature extraction unit to perform multi-dimensional feature extraction on the battery historical operation data through the preset first fault detection model according to the time sequence. In this way, the multi-dimensionality and time sequence influences of fault feature sources can be fully integrated to obtain more accurate fault detection feature data, which in turn can facilitate the derivation of more reliable fault detection results.

In some embodiments, the batch computing module includes: a first computing unit, configured to perform batch computing on the fault detection feature data through the batch computing engine to obtain corresponding intermediate parameters; a generation unit, configured to generate an intermediate table in a corresponding time sequence based on the intermediate parameters; and a third transmission unit, configured to transmit the intermediate table to the second data warehouse to update an existing intermediate table stored in the second data warehouse.

According to the embodiments of this application, the batch computing module includes a first computing unit, a generation unit, and a third transmission unit, where the first computing unit is configured to perform batch computing on a large amount of fault detection feature data obtained from massive amounts of battery historical operation data through the batch computing engine to quickly obtain corresponding intermediate parameters, facilitating improved data computation efficiency in big data processing scenarios. The generation unit is configured to generate an intermediate table in a corresponding time sequence based on the intermediate parameters, followed by the third transmission unit to transmit the intermediate table to the second data warehouse for storage for invocation by the stream computing platform. The intermediate parameters are stored as the intermediate table in the second data warehouse before being used for fusion computations, allowing for faster and more convenient invocation, reducing wait times for real-time computations, lowering the data processing complexity of stream computing, and facilitating improved computation efficiency in real-time fault detection processes.

In some embodiments, the stream computing platform further includes: a real-time acquisition module, configured to acquire the intermediate parameters and battery real-time operation data in real time through the stream computing engine from the second data warehouse; a determination module, configured to determine corresponding battery real-time status data based on the battery real-time operation data; a splicing module, configured to splice the battery real-time operation data and the intermediate parameters in the intermediate table; and a computing module, configured to perform computing on the spliced data through a preset second fault detection model and output fault detection data of a corresponding battery and identity information of the battery.

According to the embodiments of this application, the real-time acquisition module of the stream computing platform can continuously acquire the intermediate parameters and battery real-time operation data in real time through the stream computing engine from the second data warehouse in a stream computing manner, and the determination module determines the corresponding battery real-time status data based on the battery real-time operation data. The splicing module then splices the battery real-time operation data and the intermediate parameters in the intermediate table to form a new data table in a corresponding time sequence, so that the computing module can read data in the data table, perform computations through the preset second fault detection model, and output the corresponding fault detection data and the identity information of the battery corresponding to the data, facilitating the acquisition of fault detection data for each battery in big data battery risk identification and management scenarios.

In some embodiments, the system further includes a warning module and a service subsystem, where the warning module is configured to generate warning information based on the fault detection data of the corresponding battery and the identity information of the battery and send the warning information to the service subsystem; and the service subsystem is configured to query for a target terminal corresponding to the identity information of the battery based on the warning information to generate service information corresponding to the target terminal and the fault detection data.

According to the embodiments of this application, when the fault detection data indicates that the battery has a fault or abnormal condition, warning information can be generated and sent to the service subsystem so that the service subsystem is enabled to query for the target terminal corresponding to the battery identity information and send the relevant service information to the target terminal for user awareness, achieving big data battery fault risk warning.

According to a second aspect, an embodiment of this application provides a battery fault detection method including:
acquiring corresponding battery historical operation data from a first data warehouse; performing feature extraction on the battery historical operation data through a preset first fault detection model to obtain corresponding fault detection feature data; performing batch computing on the fault detection feature data through a batch computing engine to obtain corresponding intermediate parameters; acquiring the intermediate parameters and battery real-time operation data in real time through a stream computing platform; and performing fusion computations on the intermediate parameters and battery real-time operation data using a second fault detection model to obtain a fault detection result of a corresponding battery.

According to this embodiment of this application, the first data warehouse can store massive amounts of historical operation data, and based on these massive amounts of historical operation data over a sufficient time span, the feature extraction is performed through the first fault detection model to obtain more accurate fault detection feature data. Then, batch computing is performed on the large amount of the fault detection feature data through the batch computing engine to quickly obtain corresponding intermediate parameters, ensuring that subsequently, the stream computing engine can acquire the intermediate parameters in a timely manner in performing real-time fusion computations. The intermediate parameters and battery real-time operation data can be acquired in real time through the stream computing engine for fusion computations on these data using the second fault detection model to obtain a fault detection result of the battery. Since the fault detection result is derived through corresponding feature extraction and fusion computations from the historical operation data and real-time operation data of the battery, the accuracy rate is higher, the false alarm rate of battery risk identification is reduced, and the reliability of battery fault detection is improved. Moreover, in this embodiment of this application, real-time acquisition and computation processing of large-scale streaming data (that is, battery real-time operation data) can be performed based on the stream computing engine, and the batch computing engine provides fast computation capability for the intermediate parameters before the computation processing, further ensuring real-time execution of the computation processing. Therefore, this embodiment of this application can ensure the real-time nature of fault detection while taking the reliability of the detection result into account, facilitating timely fault response to battery fault risks and providing a guarantee for the safe operation of power batteries.

In some embodiments, before the performing feature extraction on the battery historical operation data through a preset first fault detection model, the method further includes: acquiring battery historical operation sample data within a target duration from the first data warehouse; and performing multi-dimensional feature extraction on the battery historical operation sample data to construct the first fault detection model about corresponding fault features.

According to the embodiments of this application, a large amount of historical operation data stored in the first data warehouse within a target duration can be used as samples (that is, battery historical operation sample data) for multi-dimensional feature extraction, and fault features in each dimension can be obtained to construct the corresponding first fault detection model. Because there is a large amount of historical operation data used as training samples, when the constructed data model is applied for feature extraction, a more accurate extraction result can be obtained.

In some embodiments, the performing feature extraction on the battery historical operation data through a preset first fault detection model to obtain corresponding fault detection feature data includes: inputting battery historical operation data for a corresponding sampling period into the first fault detection model according to a time sequence at a preset sampling time; and performing multi-dimensional feature extraction on the battery historical operation data through the first fault detection model to obtain corresponding fault detection feature data.

According to the embodiments of this application, the battery historical operation data for a corresponding sampling period is input into the first fault detection model according to a time sequence at a preset sampling time, enabling the first fault detection model to perform multi-dimensional feature extraction on the battery historical operation data according to the time sequence. In this way, the multi-dimensionality and time sequence influences of fault feature sources can be fully integrated to obtain more accurate fault detection feature data, which in turn can facilitate the derivation of more reliable fault detection results.

In some embodiments, after the performing batch computing on the fault feature data through a batch computing engine to obtain corresponding intermediate parameters, the method further includes: generating an intermediate table in a corresponding time sequence based on the intermediate parameters; and inputting the intermediate table to a preset second data warehouse to update an existing intermediate table stored in the second data warehouse, the second data warehouse being a real-time data warehouse.

According to the embodiments of this application, the intermediate parameters are stored in the form of the intermediate table in the second data warehouse before being used for fusion computations, allowing for faster and more convenient invocation, reducing wait times for real-time computations, lowering the data processing complexity of stream computing, and facilitating improved computation efficiency in real-time fault detection processes.

In some embodiments, the acquiring the intermediate parameters and battery real-time operation data in real time through a stream computing engine for fusion computations using a second fault detection model to obtain a fault detection result of a corresponding battery includes: acquiring the intermediate parameters and battery real-time operation data in real time through the stream computing engine from the second data warehouse; determining corresponding battery real-time status data based on the battery real-time operation data; splicing the battery real-time status data and the intermediate parameters in the intermediate table; and performing computing on the spliced data through a preset second fault detection model and outputting fault detection data of a corresponding battery and identity information of the battery.

According to the embodiments of this application, the intermediate parameters and battery real-time operation data are acquired continuously and in real time through the stream computing engine from the second data warehouse; the corresponding battery real-time status data is continuously updated based on the battery real-time operation data; and then the battery real-time status data and the intermediate parameters in the intermediate tables are spliced to form a new data table in a corresponding time sequence. Then, based on the support from the stream computing engine, the second fault detection model can continuously read data in the data table to perform computations and output the corresponding fault detection data and the identity information of the battery corresponding to the data, thereby facilitating the real-time acquisition of fault detection data for each battery in big data battery fault risk identification and management scenarios and improving the response capability to battery fault risks.

In some embodiments, after the obtaining a fault detection result of a corresponding battery, the method further includes: generating warning information based on the fault detection data of the corresponding battery and the identity information of the battery; and sending the warning information to the service subsystem so that the service subsystem can query for a target terminal corresponding to the identity information of the battery based on the warning information and generate service information corresponding to the target terminal and the fault detection data.

According to the embodiments of this application, when the fault detection data indicates that the battery has a fault or abnormal condition, warning information can be generated and sent to the service subsystem so that the service subsystem is enabled to query for the target terminal corresponding to the battery identity information and send the relevant service information to the target terminal for user awareness, achieving big data battery fault risk warning.

According to a third aspect, an embodiment of this application provides an electronic device, including a processor, a memory, and a program or instructions stored in the memory and capable of running on the processor, where when the program or instructions are executed by the processor, the steps of the battery fault detection method according to any one of the embodiments of the first aspect are implemented.

According to a fourth aspect, an embodiment of this application provides a readable storage medium, where the readable storage medium has stored thereon a program or instructions, and when the program or instructions are executed by a processor, the steps of the battery fault detection method according to any one of the embodiments of the first aspect are implemented.

According to a fifth aspect, an embodiment of this application provides a chip, where the chip includes a processor and a communication interface, the communication interface is coupled to the processor, and the processor is configured to run a program or instructions to implement the steps of the battery fault detection method according to any one of the embodiments of the first aspect.

According to a sixth aspect, an embodiment of this application provides a computer program product, where when instructions in the computer program product are executed by a processor of an electronic device, the electronic device is enabled to perform the steps of the battery fault detection method according to any one of the embodiments of the first aspect.

The foregoing description is merely an overview of the technical solution of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

To describe the technical solutions in embodiments of this application more clearly, the following briefly describes the accompanying drawings for describing the embodiments of this application.
FIG. 1 is a schematic structural diagram of a battery fault detection system according to an embodiment of this application;
FIG. 2 is a schematic diagram of a battery fault detection system performing fault detection in a specific embodiment of this application;
FIG. 3 is a flowchart of a battery fault detection method according to an embodiment of this application; and
FIG. 4 is a schematic diagram of a hardware structure of an electronic device according to an embodiment of this application.

### DESCRIPTION OF EMBODIMENTS

The following further describes embodiments of this application in detail with reference to the accompanying drawings and examples. The following detailed description of embodiments and the accompanying drawings are intended to illustrate the principle of this application rather than to limit the scope of this application, meaning this application is not limited to the embodiments as described.

In the description of this application, it should be noted that, unless otherwise stated, "multiple" means at least two; and the orientations or positional relationships indicated by the terms "upper", "lower", "left", "right", "inside", "outside", and the like are merely for ease and brevity of description of this application rather than indicating or implying that the means or components mentioned must have specific orientations or must be constructed or manipulated according to particular orientations. These terms shall therefore not be construed as limitations on this application. In addition, the terms "first", "second", "third", and the like are merely for the purpose of description and shall not be understood as any indication or implication of relative importance. "Perpendicular" is not strictly perpendicular, but within the allowable range of error. "Parallel" is not strictly parallel, but within the allowable range of error.

Reference to "embodiment" in this application means that specific features, structures, or characteristics described with reference to the embodiment may be included in at least one embodiment of this application. The word "embodiment" appearing in various places in this specification does not necessarily refer to the same embodiment or an independent or alternative embodiment that is exclusive of other embodiments. Persons skilled in the art explicitly and implicitly understand that an embodiment described in this application may combine with another embodiment.

In the field of power battery fault detection, due to the strong correlation between the faults of power batteries and the time sequence, currently in power battery fault identification, computations usually need to be performed for data over a long time span to ensure the reliability of a warning result. Therefore, currently in providing risk battery warning based on a big data fault detection platform, it usually requires computing and processing data over 1 to 2 years from hundreds of thousands to millions of vehicles. Currently, to meet the requirements of big data storage and processing capabilities, big data platforms are used for power battery fault detection in most cases. However, even with very powerful computing resources, big data platforms face slow processing speeds when handling such large batches of data, taking days or even weeks to process data of this magnitude. To address this, a common solution generally is to shorten the data collection period to reduce the amount of data used for fault detection, thereby improving the real-time nature of fault detection. However, this comes at the cost of sacrificing fault detection accuracy, as faults of a power battery have a strong correlation with the time sequence, and short-term data often cannot reflect the true state of the battery.

To solve some or all of the problems in the related arts, embodiments of this application provide a battery fault detection system and method, and a device. With feature extraction and batch computing based on massive amounts of battery historical operation data stored in an offline warehouse, intermediate parameters of historical operation data corresponding to fault detection features can be quickly obtained. The intermediate parameters and battery real-time operation data are obtained in real time by the stream computing engine for fusion computation, which can quickly result in more accurate real-time fault detection results, ensuring both the accuracy and real-time nature of the detection results in large-scale battery risk identification and management scenarios. The following first describes the battery fault detection system provided in the embodiments of this application.

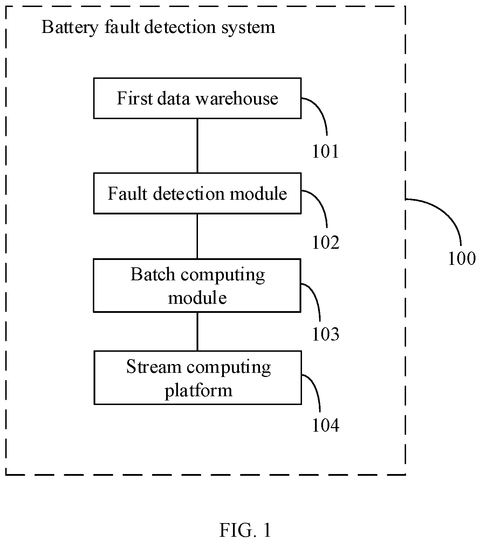

FIG. 1 shows a schematic structural diagram of a fault detection system provided in an embodiment of this application. As shown in FIG. 1, the system 100 includes:
a first data warehouse 101, configured to store battery historical operation data;
a fault detection module 102, configured to acquire corresponding battery historical operation data from the first data warehouse for feature extraction to obtain corresponding fault detection feature data;
a batch computing module 103, configured to perform batch computing on the fault detection feature data through a batch computing engine to obtain corresponding intermediate parameters; and
a stream computing platform 104, configured to acquire the intermediate parameters and battery real-time operation data in real time through a stream computing engine for fusion computations to obtain a fault detection result of a corresponding battery.

According to this embodiment of this application, the first data warehouse 101 can store massive amounts of historical operation data, from which the fault detection module 102 can acquire historical operation data over a sufficient time span for feature extraction, thereby obtaining more accurate and reliable fault detection feature data. Then, the batch computing module 103 performs batch computing on the large amount of fault detection feature data through the batch computing engine to quickly obtain corresponding intermediate parameters, ensuring that subsequently, the stream computing platform 104 can acquire the intermediate parameters in a timely manner in performing real-time fusion computations. The stream computing platform 104 can acquire the intermediate parameters and battery real-time operation data in real time through the stream computing engine for fusion computations to obtain a real-time fault detection result of a corresponding battery. Since the fault detection result is derived through corresponding feature extraction and fusion computations from the historical operation data and real-time operation data of the battery, the accuracy rate is higher, the false alarm rate of battery risk identification is reduced, and the reliability of battery fault detection is improved. Moreover, in this embodiment of this application, the stream computing platform 104 can be used to perform real-time acquisition and computation processing of large-scale streaming data (that is, battery real-time operation data) based on the stream computing engine, and the batch computing module 103 provides fast computation capability for the intermediate parameters before the computation processing, further ensuring real-time execution of the computation processing. Therefore, this embodiment of this application can ensure the real-time nature of fault detection while taking the reliability of the detection result into account, facilitating timely fault response to battery fault risks and providing a guarantee for the safe operation of power batteries.

In this embodiment of the application, the first data warehouse 101 may be an offline data warehouse, such as a Hive warehouse. The fault risk of the battery also increases as the battery usage time increases. Based on the strong time sequence correlation in battery fault risks, massive amounts of battery historical operation data are stored in an offline data warehouse in this embodiment, so that the system can obtain accurate fault detection results by performing computations on historical operation data over a sufficient time span, improving the reliability of fault warnings.

In some examples, for scenarios in which terminal battery fault risks are monitored through a big data platform, the first data warehouse can store vehicle power battery operation data over 1 to 2 years acquired by the big data platform from terminals (such as in-vehicle terminals) of hundreds of thousands to millions of vehicles, to provide sufficient data samples for subsequent extraction, detection, and identification of fault features.

For example, the battery historical operation data may include the voltage value, current value, temperature value, state of charge (State Of Charge, SOC) value, and state of health (State Of Health, SOH) value of the battery at historical times, but is not limited thereto.

In some examples, the first data warehouse 101 can clean and normalize the massive amounts of acquired battery data before storing it for invocation by the fault detection module 102.

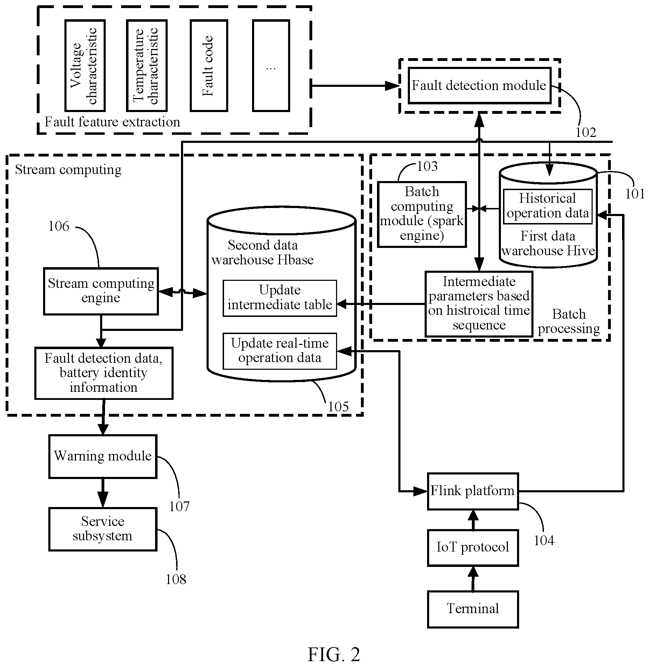

In some embodiments, referring to FIG. 2, the system 100 further includes a second data warehouse 105. The second data warehouse 105 is configured to store the intermediate parameters and battery real-time operation data in real time for access by the stream computing platform 104.

In the embodiments of this application, since the real-time operation data of the battery is continuously updated, to enable the stream computing platform to acquire in real time and process in a timely and effective manner the real-time operation data generated by the battery, the system in the embodiments can store in real time the intermediate parameters computed by the batch computing module and the battery real-time operation data acquired from the terminal through the data warehouse, thereby providing a guarantee for data reading in the streaming fusion computation process of the stream computing platform.

For example, the second data warehouse 105 may be a real-time data warehouse, such as an Hbase warehouse. The second data warehouse 105 can acquire and store each frame of real-time operation data of the battery in real time, and correspondingly update the real-time operation data of the battery for invocation by the stream computing platform 104. In this way, the stream computing platform 104 can continuously perform fusion computations based on the feature data related to the battery historical operation data and each frame of real-time operation data through the stream computing engine, to obtain a more accurate and reliable real-time fault detection result for the battery, thereby facilitating real-time fault risk prediction.

For example, the battery real-time operation data may include the real-time voltage value, current value, temperature value, state of charge (State Of Charge, SOC) value, and state of health (State Of Health, SOH) value of the battery, but is not limited to thereto. Correspondingly, the battery real-time status data stored in the second data warehouse 105 may include the voltage value, current value, temperature value, SOC value, SOH value, and the like.

To ensure the real-time nature of data processing, optionally, in this embodiment of this application, the stream computing platform 104 may include:
a data interface, configured to collect real-time operation data of corresponding batteries from each terminal through Internet of Things protocols;
a first transmission unit, configured to transmit the real-time operation data to the second data warehouse to update existing battery real-time operation data stored in the second data warehouse; and
a second transmission unit, configured to transmit the real-time operation data to the first data warehouse for storage to update the battery historical operation data.

In some examples, referring to FIG. 2, the stream computing platform 104 may be a processing platform including Flink stream computing engine 106 (hereinafter referred to as "Flink platform"). The Flink platform provides an open-source stream processing framework and distributed stream computing engine 106 and can execute stream data programs in a data-parallel and pipelined manner, enabling continuous and real-time acquisition of battery real-time operation data from terminals and storing the data in the first data warehouse 101 and the second data warehouse 105, respectively. In the second data warehouse 105, the new real-time operation data overwrites the existing data, achieving continuous data updates. In the first data warehouse 101, both the new real-time operation data and the existing battery historical operation data are stored in the first data warehouse 101, enabling continuous data accumulation and overall data updates.

Specifically, in a real-time fault detection process, the fault detection module 102 acquires historical operation data from the first data warehouse 101 for feature extraction, obtains corresponding fault detection feature data for batch computing, and generates intermediate parameters of these historical operation data. The intermediate parameters are stores in the second data warehouse 105 and combined with the real-time operation data acquired by the second data warehouse 105 for fusion computations. Concurrently, the real-time operation data acquired during this process is stored in the first data warehouse 101 in preparation for the next real-time fault detection.

Moreover, the Flink platform based on the stream computing engine can continuously and sequentially acquire the foregoing real-time operation data and intermediate parameters, that are updated over time, from the second data warehouse in a stream computing manner in the fusion computation process and perform fusion computations of data. In this way, in the result obtained from the fusion computations, the time sequence attribute of the historical operation data and real-time operation data of the battery can be retained, so that the fault detection result and the data are strongly correlated in time sequence, conforming to the objective laws of the battery operating state changing over time and thereby improving the accuracy of the fault detection result.

In this example, the Flink platform possesses the advantages of supporting high throughput, low latency, and high performance, ensuring real-time data processing in large-scale battery fault detection scenarios. The Flink platform can also efficiently process data according to continuous events, with better fault tolerance capability based on lightweight distributed snapshots (Snapshot), ensuring the reliability and durability of the Flink platform.

In other examples, the stream computing platform can also be a real-time platform using other types of stream computing engines to implement the functions of the stream computing platform described in this application.

The Flink platform establishes communication connections with terminals based on the Internet of Things protocols via the data interface. It can be understood that the Internet of Things protocols may be one or more of the message queue telemetry transport (Message Queue Telemetry Transport, MQTT) protocol, constrained application protocol (Constrained Application Protocol, CoAP), lightweight machine-to-machine (Lightweight Machine-To-Machine, LwM2M) protocol, hypertext transfer protocol (HyperText Transfer Protocol, HTTP), narrow band Internet of Things (Narrow Band Internet of Things, NB-IoT) protocol, and the like, which is not specifically limited in this application embodiment.

The terminals monitor the battery real-time operation data in real time and upload the battery real-time operation data obtained from monitoring to the Flink platform in real time. After receiving the data uploaded by the terminals, the Flink platform transmits the data to the first data warehouse 101 for storage through the second transmission unit to update the battery historical operation data stored in the first data warehouse 101. The Flink platform also transmits data received from the terminals to the second data warehouse 105 for storage through the first transmission unit to update existing battery real-time status data stored in the second data warehouse 105.

According to the embodiments of this application, the data platform 105 collects real-time operation data of batteries from each terminal through the data interface based on the Internet of Things protocols, completing big data collection for risk identification for batches of batteries, thereby facilitating large-scale battery risk identification and management. The acquired real-time operation data is transmitted to the second data warehouse 105 through the first transmission unit to continuously update the existing battery real-time operation data, thereby continuously providing a data basis for fusion computations for the stream computing platform 104 in real time, improving the real-time nature and reliability of large-scale battery risk identification and management. Moreover, the real-time operation data is also transmitted to the first data warehouse 101 for storage through the second transmission unit, updating the battery historical operation data, accumulating timeliness data basis required for feature extraction by the fault detection module 102, facilitating the improvement of the robustness of the fault detection module 102 in performing computations based on massive amounts of data and the improvement of the accuracy of battery fault detection.

In some embodiments, the fault detection module 102 may include:
a data acquisition unit, configured to acquire, at a preset sampling time, battery historical operation data for a corresponding sampling period from the first data warehouse 101 and input the data into a feature extraction unit according to a time sequence; and
the feature extraction unit, configured to perform multi-dimensional feature extraction on the battery historical operation data through a preset first fault detection model and output corresponding fault detection feature data.

In this embodiment, the sampling period may be a time metric such as year, month, day, hour, and minute, and the preset sampling time may also be set at intervals in metric such as day, hour, minute, and second. The fault detection module 102 acquires battery historical operation data for a corresponding sampling period from the first data warehouse 101 at a preset sampling time through the data acquisition unit and inputs the data into the feature extraction unit according to a time sequence based on times of the acquired battery historical operation data, to perform multi-dimensional feature extraction through the preset first fault detection model to obtain fault detection feature data.

For example, before performing feature extraction on the battery historical operation data, the feature extraction unit can first acquire sufficient battery historical operation data samples from the first data warehouse 101 and extract voltage characteristics, temperature features, current characteristics, corresponding fault codes (such as thermal runaway fault codes), and the like from the samples to construct a multi-dimensional first fault detection model. The first fault detection model can be used to acquire battery historical operation data for predictive identification and output corresponding fault detection feature data such as a corresponding fault code. In some specific examples, the constructed first fault detection model may be a matrix model, neural network model, decision tree model, or the like, which is not uniquely limited in this embodiment.

Based on the first fault detection model, the feature extraction unit acquires battery historical operation data for the sampling period to perform multi-dimensional feature extraction and identification and output fault detection feature data. In this way, the multi-dimensionality and time sequence influences of fault feature sources can be fully integrated to obtain more accurate fault detection feature data, which in turn can facilitate the derivation of more reliable fault detection results.

In some embodiments, the batch computing module 103 may specifically include:
a first computing unit, configured to perform batch computing on the fault detection feature data through the batch computing engine to obtain corresponding intermediate parameters;
a generation unit, configured to generate an intermediate table in a corresponding time sequence based on the intermediate parameters; and
a third transmission unit, configured to transmit the intermediate table to the second data warehouse to update an existing intermediate table stored in the second data warehouse.

For example, the batch computing engine may be a Spark batch computing engine. The Spark batch computing engine has the advantages of being fast and general, capable of performing batch computing on massive amounts of fault detection feature data to obtain corresponding intermediate parameters and generate intermediate tables in a corresponding time sequence. In a specific example, the intermediate parameters may include battery number/id, detection time consumption, report time, current value, voltage value, SOC value, SOH value, fault code, battery status, and the like, and such kind of data is generated into an intermediate table that is stored in the second data warehouse 105 to facilitate invocation by the stream computing platform 104 in real-time fault detection, reducing data computation complexity in stream computing.

In the embodiments of this application, in battery fault risk warning scenarios on a big data platform, the system 100 usually needs to process historical operation data over 1 to 2 years for hundreds of thousands or even millions of vehicles, and the amount of data processed reaches the Pb level. If a big data platform in related art is used to process such a huge amount of data, the processing speed will be very slow, generally taking days or even weeks to complete the processing. If warning measures need to be triggered after processing, it will take more than one day of response time. In this way, if, in practical applications, the battery fails within two days after triggering of the warning, the requirement for early warning of fault risks cannot be met in the related art. However, in the embodiments of this application, the system 100 periodically acquires sufficient historical operation data of the battery in advance from the offline first data warehouse 101 through the fault detection module 102 for fault detection, obtains fault detection feature data for batch computing, and generates the intermediate table that is stored to the second data warehouse 105. In this way, the stream computing platform 104 can directly invoke the data for real-time fault detection without additionally computing the features of the historical operation data, improving the rapid response capability in real-time fault risk identification and warning scenarios.

According to the embodiments of this application, the system 100 uses the Spark batch computing engine of the batch computing module 106 to support Spark batch computing during the feature extraction and identification process of massive amounts of data by the fault detection module 102, and quickly obtains corresponding intermediate parameters, facilitating improved data computation efficiency in big data processing scenarios. The intermediate table generated from the intermediate parameters is transmitted to the second data warehouse 105 for storage, allowing the stream computing platform 104 to invoke them more quickly and conveniently, reducing wait times for real-time computations, lowering the data processing complexity of stream computing, and facilitating further improved computation efficiency in real-time fault detection processes.

In some embodiments, the stream computing platform 104 may include:
a real-time acquisition module, configured to acquire the intermediate parameters and battery real-time operation data in real time through the stream computing engine from the second data warehouse;
a determination module, configured to determine corresponding battery real-time status data based on the battery real-time operation data;
a splicing module, configured to splice the battery real-time status data and the intermediate parameters in the intermediate table; and
a computing module, configured to perform computing on the spliced data through a preset second fault detection model and output fault detection data of a corresponding battery and identity information of the battery.

In this embodiment of this application, referring to FIG. 2, a real-time acquisition module of the stream computing platform can continuously and sequentially acquire the intermediate parameters and real-time operation data of the battery in real time through the stream computing engine 106 from the second data warehouse in a stream computing manner, and the determination module determines the corresponding battery real-time status data based on the battery real-time operation data. The battery real-time status data can be stored in the form of a table. Therefore, when splicing, the splicing module can splice the table of the battery real-time status data and the foregoing intermediate table in the second data warehouse 105 to form a new table. Based on this new table, the computing module reads corresponding data and inputs the data into a preset second fault detection model. Fault identification and computation can be performed by integrating the historical operation data features and real-time operation data, to obtain the fault detection data and identity information (such as Identity document, id) for each battery. Moreover, based on the support from the stream computing engine, the time sequence attribute of the historical operation data and real-time operation data of the battery can be retained, so that the fault detection result and the data are strongly correlated in time sequence, conforming to the objective laws of the battery operating state changing over time, thereby improving the accuracy of the fault detection result.

In some specific examples, the second fault detection model may be a pre-constructed matrix model, neural network model, decision tree model, or the like. The computing module inputs the spliced battery real-time status data and intermediate parameters into the corresponding second fault detection model for processing, and outputs the fault detection data and identity information for each battery. For example, the spliced historical and real-time battery id, current value, voltage value, fault code, SOC value, and the like are input into the model, and data for each battery id is output such as whether a fault risk occurs and a fault code of the fault risk that has occurred, thereby obtaining the fault detection data for each corresponding battery in big data battery risk identification and management scenarios.

To achieve early warning, optionally, in some embodiments, the system 100 may further include a warning module 107 and a service subsystem 108, where:
the warning module 107 is configured to generate warning information based on the fault detection data of the corresponding battery and the identity information of the battery and send the warning information to the service subsystem 108; and the service subsystem 108 is configured to query for a target terminal corresponding to the identity information of the battery based on the warning information to generate service information corresponding to the target terminal and the fault detection data.

For example, the service subsystem 108 may be an after-sales service system of the operator. For example, if the data output by the stream computing platform 104 indicates that the power battery with battery id "123" will have a thermal runaway risk, the warning model 107 can generate warning information based on these data. The warning information, which may include the battery id and an identification of the fault risk, is sent to the service subsystem 108 in real time.

After receiving the warning information, the service subsystem 108 can look up the target terminal corresponding to the battery id and send the relevant service information to the target terminal for user awareness, thereby intercepting the real-time risk of the corresponding battery through the terminal and indicating risk intervention for the battery, such as indicating that the battery needs to be replaced. This can achieve a closed-loop process in the detection and warning of big data battery fault risks, with a low false alarm rate and high reliability.

The fault detection system provided in this embodiment of this application is particularly suitable for fault risk identification and warning of power batteries in new energy vehicles based on big data platforms, without increasing the hardware cost of the battery management system (Battery Management System, BMS), and is easy to deploy. Moreover, the offline-based batch processing engine can train historical operation data, optimize fault detection feature data parameters, improve identification accuracy of fault features, and perform fusion computations by sampling each frame of real-time operation data based on stream computing, to obtain more reliable fault detection results, providing warning protection for the safety of users and vehicle batteries.

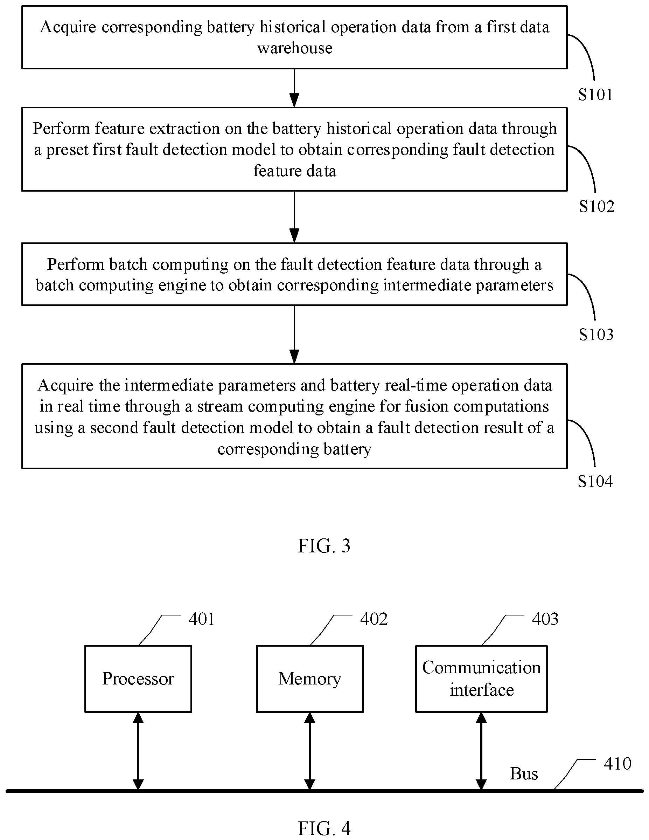

An embodiment of this application further provides a fault detection method. FIG. 3 shows a flowchart of a fault detection method provided in an embodiment of this application. As shown in FIG. 3, the method may include S101 to S104:
S 101. Acquire corresponding battery historical operation data from a first data warehouse;
S102. Perform feature extraction on the battery historical operation data through a preset first fault detection model to obtain corresponding fault detection feature data;
S 103. Perform batch computing on the fault detection feature data through a batch computing engine to obtain corresponding intermediate parameters; and
S 104. Acquire the intermediate parameters and battery real-time operation data in real time through a stream computing engine for fusion computations using a second fault detection model to obtain a fault detection result of a corresponding battery.

According to this embodiment of this application, the first data warehouse can store massive amounts of historical operation data, and based on these massive amounts of historical operation data over a sufficient time span, the feature extraction is performed through the first fault detection model to obtain more accurate fault detection feature data. Then, batch computing is performed on the large amount of the fault detection feature data through the batch computing engine to quickly obtain corresponding intermediate parameters, ensuring that subsequently, the stream computing engine can acquire the intermediate parameters in a timely manner in performing real-time fusion computations. The intermediate parameters and battery real-time operation data can be acquired in real time through the stream computing engine for fusion computations on these data using the second fault detection model to obtain a fault detection result of the battery. Since the fault detection result is derived through corresponding feature extraction and fusion computations from the historical operation data and real-time operation data of the battery, the accuracy rate is higher, the false alarm rate of battery risk identification is reduced, and the reliability of battery fault detection is improved. Moreover, in this embodiment of this application, real-time acquisition and computation processing of large-scale streaming data (that is, battery real-time operation data) can be performed based on the stream computing engine, and the batch computing engine provides fast computation capability for the intermediate parameters before the computation processing, further ensuring real-time execution of the computation processing. Therefore, this embodiment of this application can ensure the real-time nature of fault detection while taking the reliability of the detection result into account, facilitating timely fault response to battery fault risks and providing a guarantee for the safe operation of power batteries.

In some embodiments, the first data warehouse may be an offline data warehouse, such as a Hive warehouse, capable of storing massive amounts of battery historical operation data and providing historical operation data over a sufficient time span for relevant computations for fault detection, to obtaining accurate fault detection results and improve the reliability of the fault warning. The battery historical operation data may include the voltage value, current value, temperature value, state of charge (State Of Charge, SOC) value, and state of health (State Of Health, SOH) value of the battery at historical times, but is not limited thereto.

In some examples, before S 101 of acquiring corresponding battery historical operation data from a first data warehouse, the method may further include: acquiring massive amounts of historical operation data of the battery, performing data cleaning and normalization processing, and storing the data to the first data warehouse for invocation by the first fault detection model.

In some embodiments, to ensure efficient execution of feature extraction, before S 102 of performing feature extraction on the battery historical operation data through a preset first fault detection model, the method further includes:
acquiring battery historical operation sample data within a target duration from the first data warehouse; and
performing multi-dimensional feature extraction on the battery historical operation sample data to construct the first fault detection model about corresponding fault features.

For example, the battery historical operation sample data just takes sufficient battery historical operation data as samples, and voltage characteristics, temperature features, current characteristics, corresponding fault codes (such as thermal runaway fault codes), and the like are extracted from the samples to construct a multi-dimensional first fault detection model. The first fault detection model can be used to acquire battery historical operation data for predictive identification and output fault detection feature data corresponding to different fault risks, such as a corresponding fault code. In some specific examples, the constructed first fault detection model may be a matrix model, neural network model, decision tree model, or the like, which is not uniquely limited in this embodiment. Moreover, it should be understood that the construction of matrix models, neural network models, or decision tree models based on sample data are all mature techniques in the art. Details are not described herein again.

According to the embodiments of this application, a large amount of historical operation data stored in the first data warehouse within a target duration can be used as samples (that is, battery historical operation sample data) for multi-dimensional feature extraction, and fault features in each dimension can be obtained to construct the corresponding first fault detection model. Because there is a large amount of historical operation data used as training samples, when the constructed data model is applied for feature extraction, efficient execution of feature extraction can be ensured to obtain a more accurate extraction result.

For example, step 102 of performing feature extraction on the battery historical operation data through a preset first fault detection model to obtain corresponding fault detection feature data may specifically include:
inputting battery historical operation data for a corresponding sampling period into the first fault detection model according to a time sequence at a preset sampling time; and
performing multi-dimensional feature extraction on the battery historical operation data through the first fault detection model to obtain corresponding fault detection feature data.

In this embodiment, the sampling period may be a time metric such as year, month, day, hour, and minute, and the preset sampling time may also be set at intervals in metric such as year, month, day, hour, and minute. In the embodiments of this application, the battery historical operation data for a corresponding sampling period is input into the first fault detection model according to a time sequence at a preset sampling time, enabling the first fault detection model to perform multi-dimensional feature extraction on the battery historical operation data according to the time sequence. In this way, the multi-dimensionality and time sequence influences of fault feature sources can be fully integrated to obtain more accurate fault detection feature data, which in turn can facilitate the derivation of more reliable fault detection results.

In large-scale battery fault risk detection scenarios, massive amounts of battery historical operation data need to be acquired for processing. To improve data processing efficiency and thus improve the response capability to fault risks, in some embodiments of this application, step S 103 of performing batch computing on the fault detection feature data through the batch computing engine is performed, which can improve the processing capability of the system for massive amounts of data. In this way, in massive battery fault risk identification scenarios, the fault detection feature data obtained by extracting the massive amounts of battery historical operation data can be efficiently processed, and the intermediate parameters about the fault detection features can be quickly obtained for the stream computing engine to invoke. To ensure efficient execution of stream computations performed by the stream computing engine, for example, after step 103 of performing batch computing on the fault feature data through a batch computing engine to obtain corresponding intermediate parameters, the method further includes:
generating an intermediate table in a corresponding time sequence based on the intermediate parameters; and
inputting the intermediate table to a preset second data warehouse to update an existing intermediate table stored in the second data warehouse, the second data warehouse being a real-time data warehouse.

For example, the batch computing engine may be a Spark batch computing engine. The Spark batch computing engine has the advantages of being fast and general, capable of performing batch computing on massive amounts of fault detection feature data to obtain corresponding intermediate parameters and generate intermediate tables in a corresponding time sequence. In a specific example, the intermediate parameters may include battery number/id, detection time consumption, report time, current value, voltage value, SOC value, SOH value, fault code, battery status, and the like, and such kind of data is generated into an intermediate table that is stored in the second data warehouse 105 to facilitate invocation by the stream computing engine in real-time fault detection and computation, reducing data computation complexity in stream computing.

In the embodiments of this application, the method is executed to periodically acquire sufficient historical operation data of the battery from the offline first data warehouse through the first fault detection model for fault detection, obtain fault detection feature data for batch computing, and generates the intermediate table that is stored to the second data warehouse. In this way, the stream computing engine can directly invoke the data for real-time fault detection without additionally computing the features of the historical operation data, reducing wait times for real-time computations, facilitating improved computation efficiency in real-time fault detection processes, and improving the rapid response capability in real-time fault risk identification and warning scenarios.

For example, the second data warehouse is a real-time data warehouse, such as an Hbase warehouse. Since the real-time operation data of the battery is continuously updated, to enable the stream computing platform to acquire in real time and process in a timely and effective manner the real-time operation data generated by the battery, the system in the embodiments can store in real time the intermediate parameters computed by the batch computing engine and the battery real-time operation data acquired from the terminal through the second data warehouse, thereby providing a guarantee for data reading in the fusion computation process of the stream computing engine.

Therefore, the second data warehouse is an Hbase warehouse, can acquire each frame of real-time operation data of the battery in real time, and correspondingly update the real-time status data of the battery for invocation by the stream computing engine. In this way, the second fault detection model can perform fusion computations based on the feature data related to the battery historical operation data and each frame of real-time operation data, to obtain a more accurate and reliable real-time fault detection result for the battery, thereby facilitating real-time fault risk prediction. For example, the battery real-time operation data may include the real-time voltage value, current value, temperature value, state of charge (State Of Charge, SOC) value, and state of health (State Of Health, SOH) value of the battery, but is not limited to thereto. Correspondingly, the battery real-time status data stored in the second data warehouse may include the voltage value, current value, temperature value, SOC value, SOH value, and the like.

For example, the data acquired by the first data warehouse and the second data warehouse may be collected by a stream computing platform. The stream computing platform may be a processing platform including Flink stream computing engine (hereinafter referred to as "Flink platform"), enabling continuous and real-time acquisition of battery real-time operation data from terminals and storing the data in the first data warehouse and the second data warehouse, respectively. In the second data warehouse, the new real-time operation data overwrites the existing data, achieving continuous data updates. In the first data warehouse, both the new real-time operation data and the existing battery historical operation data are stored in the first data warehouse, enabling continuous data accumulation and overall data updates.

Specifically, in a real-time fault detection process, the first fault detection model acquires historical operation data from the first data warehouse for feature extraction, obtains corresponding fault detection feature data for batch computing, and generates intermediate parameters of these historical operation data. The intermediate parameters are stores in the second data warehouse and combined with the real-time operation data acquired by the second data warehouse for fusion computations. Concurrently, the real-time operation data acquired during this process is stored in the first data warehouse in preparation for the next real-time fault detection.

Moreover, the Flink platform based on the stream computing engine can continuously and sequentially acquire the foregoing real-time operation data and intermediate parameters, that are updated over time, from the second data warehouse in a stream computing manner in the fusion computation process and perform fusion computations of data. In this way, in the result obtained from the fusion computations, the time sequence attribute of the historical operation data and real-time operation data of the battery can be retained, so that the fault detection result and the data are strongly correlated in time sequence, conforming to the objective laws of the battery operating state changing over time and thereby improving the accuracy of the fault detection result.

In some embodiments, step S104 of acquiring the intermediate parameters and battery real-time operation data in real time through a stream computing engine for fusion computations on the battery real-time status data and intermediate parameters using a second fault detection model to obtain a fault detection result of a corresponding battery may specifically include:
acquiring the intermediate parameters and battery real-time operation data in real time through the stream computing engine from the second data warehouse;
determining corresponding battery real-time status data based on the battery real-time operation data;
splicing the battery real-time status data and the intermediate parameters in the intermediate table; and
performing computing on the spliced data through a preset second fault detection model and outputting fault detection data of a corresponding battery and identity information of the battery.

In the embodiments of this application, the intermediate parameters and battery real-time operation data can be continuously acquired in real time through the stream computing engine from the second data warehouse in a stream computing manner, and the corresponding battery real-time status data can be determined based on the battery real-time operation data. The battery real-time status data can be stored in the form of a table in the second data warehouse. Therefore, when splicing, the table of the battery real-time status data and the foregoing intermediate table in the second data warehouse can be spliced to form a new data table. Based on this new data table in a corresponding time sequence, with the support of the stream computing engine, data in this data table can be continuously read by the second fault detection model for computations to obtain the fault detection data and identity information (such as Identity document, id) for each battery, thereby facilitating the real-time acquisition of fault detection data for each battery in big data battery fault risk identification and management scenarios and improving the response capability to battery fault risks. Moreover, based on the support from the stream computing engine, the time sequence attribute of the historical operation data and real-time operation data of the battery can be retained, so that the fault detection result and the data are strongly correlated in time sequence, conforming to the objective laws of the battery operating state changing over time, thereby improving the accuracy of the fault detection result.

In some specific examples, the second fault detection model can be a pre-constructed matrix model, neural network model, decision tree model, etc., and the construction method is similar to that of the first fault detection model, which will not be elaborated here.

In this embodiment, the spliced battery real-time status data and intermediate parameters are input into the corresponding second fault detection model for training and decision-making, and the fault detection data and identity information for each battery can be output. For example, the spliced historical and real-time battery id, current value, voltage value, fault code, SOC value, and the like are input into the model, and data for each battery id is output such as whether a fault risk occurs and a fault code of the fault risk that has occurred, thereby obtaining the fault detection data for each corresponding battery in big data battery risk identification and management scenarios.

To achieve early warning, optionally, in some embodiments, after obtaining a fault detection result of a corresponding battery, the method may further include:
generating warning information based on the fault detection data of the corresponding battery and the identity information of the battery; and
sending the warning information to the service subsystem so that the service subsystem is enabled to query for a target terminal corresponding to the identity information of the battery based on the warning information and generate service information corresponding to the target terminal and the fault detection data.

For example, the service subsystem may be an after-sales service system of the operator. For example, if the data output by the second fault detection model indicates that the power battery with battery id " 123" will have a thermal runaway risk, the warning model information generated may include the battery id and an identification of the fault risk. The warning information is sent to the service subsystem in real time. In this way, after receiving the warning information, the service subsystem can look up a target terminal corresponding to the battery id and send the relevant service information to the target terminal for user awareness, so that through the terminal, real-time risk interception for the corresponding battery is carried out, and risk intervention for the battery is indicated, such as an indication that the battery needs to be replaced. This can achieve a closed-loop process in the detection and warning of big data battery fault risks, with a low false alarm rate and high reliability.

The fault detection method provided in this embodiment of this application is particularly suitable for fault risk identification and warning of power batteries in new energy vehicles based on big data platforms, without requiring excessive hardware modifications to the battery management system (Battery Management System, BMS), achieving fault risk identification and warning at a relatively low cost. Moreover, the offline-based batch processing engine can train historical operation data, optimize fault detection feature data parameters, improve identification accuracy of fault features, and perform fusion computations by sampling each frame of real-time operation data based on stream computing, to obtain more reliable fault detection results, providing warning protection for the safety of users and vehicle batteries.

This application also proposes an electronic device. FIG. 4 shows a schematic structural diagram of an electronic device proposed in an embodiment of this application. The electronic device includes a processor 401 and a memory 402 having computer program instructions stored thereon.

When the computer program instructions are executed by the processor 401, the fault detection method according to any one of the foregoing embodiments is implemented.

Specifically, the processor 401 may include a central processing unit (CPU) or an application specific integrated circuit (Application Specific Integrated Circuit, ASIC), or one or more integrated circuits that may be configured to implement the embodiments of this application.

The memory 402 may include a large-capacity memory for data or instructions. By way of example and not limitation, the memory 402 may include a hard disk drive (Hard Disk Drive, HDD), a floppy disk drive, flash memory, an optical disk, a magneto-optical disk, a magnetic tape, or a universal serial bus (Universal Serial Bus, USB) drive, or a combination of two or more of the above. The memory 402 may include removable or non-removable (or fixed) media, where appropriate. The memory 402 may be internal or external to an integrated network gateway disaster recovery device, where appropriate. In specific embodiments, the memory 402 is non-volatile solid-state memory.

The memory 402 may include a read-only memory (ROM), a random access memory (RAM), a magnetic disk storage medium device, an optical storage medium device, a flash memory device, electrical, optical, or other physical/tangible memory storage device. Therefore, generally, the memory includes one or more tangible (non-transitory) computer-readable storage media (for example, memory devices) encoded with software that includes computer-executable instructions, and when the software is executed (for example, by one or more processors), it is operable to perform the operations described with reference to the method according to one aspect of this application.

In one example, the electronic device may further include a communication interface 403 and a bus 410. As shown in FIG. 4, the processor 401, memory 402, and communication interface 403 are connected via the bus 410 and complete mutual communication.

The communication interface 403 is mainly configured to implement communication between various modules, apparatuses, units, and/or devices in the embodiments of this application.

The bus 410 includes hardware, software, or both, coupling the components of the electronic device to each other. By way of example and not limitation, the bus may include an accelerated graphics port (AGP) or other graphics bus, an enhanced industry standard architecture (EISA) bus, a front-side bus (FSB), a HyperTransport (HT) interconnect, an industry standard architecture (ISA) bus, an InfiniBand interconnect, a low-pin-count (LPC) bus, a memory bus, a micro channel architecture (MCA) bus, a peripheral component interconnect (PCI) bus, a PCI-Express (PCI-X) bus, a serial advanced technology attachment (SATA) bus, a video electronics standards association local (VLB) bus, or another suitable bus or a combination of two or more of these. Bus 410 may include one or more buses, where appropriate. Although the embodiments of this application describe and illustrate specific buses, this application contemplates any suitable bus or interconnect.

In addition, in conjunction with the fault detection method in the foregoing embodiments, an embodiment of this application further provides a readable storage medium, where the readable storage medium has stored thereon a program or instructions, and when the program or instructions are executed by a processor, the steps of the battery fault detection method in the foregoing embodiments are implemented.

Moreover, an embodiment of this application further provides a chip, where the chip includes a processor and a communication interface, the communication interface is coupled to the processor, and the processor is configured to run a program or instructions to implement the steps of the battery fault detection method in the foregoing embodiments.

Moreover, an embodiment of this application further provides a computer program product, where when instructions in the computer program product are executed by a processor of an electronic device, the electronic device is enabled to perform the steps of the battery fault detection method in the foregoing embodiments.

It should be clear that this application is not limited to the specific configurations and processes described above and shown in the figures. For the sake of simplicity, detailed descriptions of known methods are omitted here. In the foregoing embodiments, several specific steps are described and illustrated as examples. However, the method process of this application is not limited to the specific steps described and illustrated. Those skilled in the art can make various changes, modifications, and additions or change the order of the steps without departing from the spirit of this application.

The functional modules shown in the foregoing structural block diagrams may be implemented as hardware, software, firmware, or a combination thereof. When implemented as hardware, it may be, for example, an electronic circuit, an application specific integrated circuit (ASIC), appropriate firmware, a plug-in, a function card, or the like. When implemented as software, elements of this application are programs or code segments used to perform required tasks. The programs or code segments may be stored in a machine-readable medium, or transmitted over a transmission medium or a communication link by a data signal carried in a carrier wave. The "machine-readable medium" may include any medium capable of storing or transmitting information. Examples of the machine-readable media include an electronic circuit, s semiconductor memory device, a ROM, a flash memory, an erasable ROM (EROM), a floppy disk, a CD-ROM, an optical disk, a hard disk, a fiber optic medium, a radio frequency (RF) link, and the like. The code segments may be downloaded via a computer network such as the Internet or an intranet.

It should also be noted that the example embodiments mentioned in this application describe some methods or systems based on a series of steps or apparatuses. However, this application is not limited to the order of the steps mentioned above. To be specific, the steps may be performed in the order mentioned in the foregoing embodiments, or in an order different from that in the embodiments, or several steps may be performed simultaneously.

Although this application has been described with reference to some preferred embodiments, various modifications to this application and replacements of the components therein with equivalents can be made without departing from the scope of this application. In particular, as long as there is no structural conflict, the various technical features mentioned in the embodiments can be combined in any manner. This application is not limited to the specific embodiments disclosed in this specification, but includes all technical solutions falling within the scope of the claims.

## Claims

1. A battery fault detection system, comprising:
a first data warehouse, configured to store battery historical operation data;
a fault detection module, configured to acquire corresponding battery historical operation data from the first data warehouse and perform feature extraction to obtain corresponding fault detection feature data;
a batch computing module, configured to perform batch computing on the fault detection feature data through a batch computing engine to obtain corresponding intermediate parameters; and
a stream computing platform, configured to acquire the intermediate parameters and battery real-time operation data in real time through a stream computing engine and perform fusion computations to obtain a fault detection result of a corresponding battery.

2. The system according to claim 1, wherein the system further comprises a second data warehouse, wherein
the second data warehouse is configured to store the intermediate parameters and battery real-time operation data in real time for access by the stream computing platform.

3. The system according to claim 2, wherein the stream computing platform comprises:
a data interface, configured to collect real-time operation data of corresponding batteries from terminals through Internet of Things protocols;
a first transmission unit, configured to transmit the real-time operation data to the second data warehouse to update existing battery real-time operation data stored in the second data warehouse; and
a second transmission unit, configured to transmit the real-time operation data to the first data warehouse for storage to update the battery historical operation data.

4. The system according to claim 2, wherein the fault detection module comprises:
a data acquisition unit, configured to acquire, at a preset sampling time, battery historical operation data for a corresponding sampling period from the first data warehouse and input the data into a feature extraction unit according to a time sequence; and
the feature extraction unit, configured to perform multi-dimensional feature extraction on the battery historical operation data through a preset first fault detection model and output corresponding fault detection feature data.

5. The system according to claim 4, wherein the batch computing module comprises:
a first computing unit, configured to perform batch computing on the fault detection feature data through the batch computing engine to obtain corresponding intermediate parameters;
a generation unit, configured to generate an intermediate table in a corresponding time sequence based on the intermediate parameters; and
a third transmission unit, configured to transmit the intermediate table to the second data warehouse to update an existing intermediate table stored in the second data warehouse.

6. The system according to claim 5, wherein the stream computing platform further comprises:
a real-time acquisition module, configured to acquire the intermediate parameters and battery real-time operation data in real time through the stream computing engine from the second data warehouse;
a determination module, configured to determine corresponding battery real-time status data based on the battery real-time operation data;
a splicing module, configured to splice the battery real-time operation data and the intermediate parameters in the intermediate table; and
a computing module, configured to perform computing on the spliced data through a preset second fault detection model and output fault detection data of a corresponding battery and identity information of the battery.

7. The system according to claim 6, wherein the system further comprises a warning module and a service subsystem, wherein
the warning module is configured to generate warning information based on the fault detection data of the corresponding battery and the identity information of the battery and send the warning information to the service subsystem; and
the service subsystem is configured to query for a target terminal corresponding to the identity information of the battery based on the warning information to generate service information corresponding to the target terminal and the fault detection data.

8. A battery fault detection method, comprising:
acquiring corresponding battery historical operation data from a first data warehouse;
performing feature extraction on the battery historical operation data through a preset first fault detection model to obtain corresponding fault detection feature data;
performing batch computing on the fault detection feature data through a batch computing engine to obtain corresponding intermediate parameters; and
acquiring the intermediate parameters and battery real-time operation data in real time through a stream computing engine, and performing fusion computations using a second fault detection model to obtain a fault detection result of a corresponding battery.

9. The method according to claim 8, wherein
before said performing feature extraction on the battery historical operation data through a preset first fault detection model, the method further comprises:
acquiring battery historical operation sample data within a target duration from the first data warehouse; and
performing multi-dimensional feature extraction on the battery historical operation sample data to construct the first fault detection model about corresponding fault features.

10. The method according to claim 8, wherein
said performing feature extraction on the battery historical operation data through a preset first fault detection model to obtain corresponding fault detection feature data comprises:
inputting battery historical operation data for a corresponding sampling period into the first fault detection model according to a time sequence at a preset sampling time; and
performing multi-dimensional feature extraction on the battery historical operation data through the first fault detection model to obtain corresponding fault detection feature data.

11. The method according to claim 10, wherein
after said performing batch computing on the fault feature data through a batch computing engine to obtain corresponding intermediate parameters, the method further comprises:
generating an intermediate table in a corresponding time sequence based on the intermediate parameters; and
inputting the intermediate table to a preset second data warehouse to update an existing intermediate table stored in the second data warehouse, the second data warehouse being a real-time data warehouse.

12. The method according to claim 11, wherein
said acquiring the intermediate parameters and battery real-time operation data in real time through a stream computing engine and performing fusion computations using a second fault detection model to obtain a fault detection result of a corresponding battery comprises:
acquiring the intermediate parameters and battery real-time operation data in real time through the stream computing engine from the second data warehouse;
determining corresponding battery real-time status data based on the battery real-time operation data;
splicing the battery real-time status data and the intermediate parameters in the intermediate table; and
performing computing on the spliced data through a preset second fault detection model and outputting fault detection data of a corresponding battery and identity information of the battery.

13. The method according to claim 12, wherein
after said obtaining a fault detection result of a corresponding battery, the method further comprises:
generating warning information based on the fault detection data of the corresponding battery and the identity information of the battery; and
sending the warning information to a service subsystem so that the service subsystem is enabled to query for a target terminal corresponding to the identity information of the battery based on the warning information and generate service information corresponding to the target terminal and the fault detection data.

14. An electronic device, comprising a processor, a memory, and a program or instructions stored in the memory and capable of running on the processor, wherein when the program or instructions are executed by the processor, the steps of the battery fault detection method according to any one of claims 8 to 13 are implemented.

15. A readable storage medium, wherein the readable storage medium has stored thereon a program or instructions, and when the program or instructions are executed by a processor, the steps of the battery fault detection method according to any one of claims 8 to 13 are implemented.

16. A chip, wherein the chip comprises a processor and a communication interface, the communication interface is coupled to the processor, and the processor is configured to run a program or instructions to implement the steps of the battery fault detection method according to any one of claims 8 to 13.

17. A computer program product, wherein when instructions in the computer program product are executed by a processor of an electronic device, the electronic device is enabled to perform the steps of the battery fault detection method according to any one of claims 8 to 13.
